(19) Europäisches Patentamt
European Patent Office
Office européen des brevets

(11) **EP 4 760 284 A1**

(12) **EUROPEAN PATENT APPLICATION**

(43) Date of publication:
**17.06.2026 Bulletin 2026/25**

(21) Application number: **24220091.3**

(22) Date of filing: **16.12.2024**

(51) International Patent Classification (IPC):
**G01R 31/28** (2006.01)    **G01R 31/327** (2006.01)
**G01R 31/11** (2006.01)

(52) Cooperative Patent Classification (CPC):
**G01R 31/3277; G01R 31/2837;** G01R 31/2827;
G01R 31/58

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **ABB SCHWEIZ AG**
**5400 Baden (CH)**

(72) Inventors:
• **Maret, Yannick**
**5405 Aargau (CH)**

• **Varga, Matija**
**8006 Zürich (CH)**
• **Zawadzki, Artur**
**30-684 Krakow (PL)**
• **Jablonski, Mateusz**
**31-435 Kraków (PL)**
• **Salido Monzu, David**
**8047 Zürich (CH)**
• **Port, Andreas**
**8152 Opfikon (CH)**

(74) Representative: **De Bortoli, Eros et al**
**Zanoli & Giavarini S.p.A.**
**Via Melchiorre Gioia, 64**
**20125 Milano (IT)**

(54) **IMPROVED MONITORING SOLUTIONS FOR ELECTRICAL SYSTEMS**

(57)    The present invention relates to a method for probing a circuit breaker electrically connected between a first line section and a second line section of an electric line.

The method comprises the following steps:
- a first step of injecting one or more first signals at a first point of said electric line, wherein said one or more first signals have frequency content at least partially included in a predefined frequency range;
- a second step of detecting one or more second signals at a second point of said electric line, wherein said one or more second signals are detected with a detection frequency band calculated based on said frequency range;
- a third step of calculating a frequency response function of said electric line in said frequency range based on the detected one or more second signals.

**FIG. 1**

EP 4 760 284 A1

## Description

The present invention relates to the field of electrical systems, preferably operating at low-voltage levels. More particularly, the present invention relates to an improved method for probing a circuit breaker in an electrical system. The probing method, according to the invention, can be advantageously adopted in monitoring methods for determining an operating state of a circuit breaker. According to a further aspect, the present invention relates to a monitoring device for determining an operating state of a circuit breaker, which is configured to carry out the probing method of the invention.

Generally, low-voltage electrical systems, such as electrical installations at residential, commercial business or industrial sites, include a number of circuit breakers configured to carry out protection functionalities of specific electrical lines or grid sections.

Normally, circuit breakers of a low-voltage electrical system have standardized dimensions and are mounted on installation rails arranged in suitable electrical panels. Typically, these devices can take a closed state, at which an electrical current is allowed to flow along a corresponding electrical line, and a tripped state or open state, at which an electrical current flowing along said electrical line is interrupted.

Nowadays, several applications, e.g., most recent smart-home systems or electrical installations including distribution and sub-distribution panels at different physical locations, require that the operating conditions of circuit breakers be monitored in order to ensure a fast intervention in case of a fault.

Most traditional solutions designed for the purpose of monitoring the operating state of a circuit breaker foresee that a side accessory is mechanically coupled to the circuit breaker in order to switch together with this latter and signal the operating state of the circuit breaker through a suitable I/O interface. Unfortunately, these solutions may be difficult to employ (e.g., during retrofitting interventions) as additional spaces in proximity of circuit breakers have to be foreseen on the installation rails to allow the above-mentioned accessory devices to be mounted. Patent document EP4119959A1 discloses a device for monitoring the operating state of a circuit breaker in a low-voltage electrical system.

The monitoring device disclosed in the above-mentioned patent document is configured to probe the circuit breaker by injecting and detecting AC signals through the electric line, on which the circuit breaker is installed, and determine the operating status of the circuit breaker based on the detection signals acquired through the above-mentioned probing activity.

The monitoring device comprises a signal transceiver comprising a transmitter arrangement, which is operatively coupled to an electric line at a first point, and receiver arrangement, which is operatively coupled to said electric line, at a second point.

The transmitter arrangement is configured to generate a first signal and inject this latter into the electric line at the above-mentioned first point. The receiver arrangement is configured to receive a second signal from the electric line at the second point in response to the injection of the above-mentioned first signal by the transmitter arrangement.

The disclosed monitoring device further comprises a signal processor, which is operatively coupled to the signal transceiver and is configured to determine the state of the circuit breaker by suitably processing the second signal received by the receiver arrangement of the signal transceiver.

A remarkable advantage of the monitoring devices of this type consists in that they are characterised by a high flexibility in installation. In fact, they do not need to be mechanically coupled to a circuit breaker and, therefore, they do not have to be mounted on the installation rails in the immediate vicinity of a circuit breaker.

These monitoring devices can thus be installed in operating positions suitably selected depending on the physical configuration of the electrical panel, for example between the installation rails or on the top or bottom of the installed circuit breakers.

Notwithstanding the above, these monitoring devices have still some aspects to improve.

It has been seen that their performances are highly influenced by the electric loads electrically connected to the electric line associated to the monitored circuit breaker and the cabling characteristics and topology of said electric line.

Depending on the nature and physical layout of the electric loads and/or the cabling characteristics and topology of the electric line, the signals injected at a specific frequency into the electric line by the monitoring devices may thus be subject to relevant frequency-dependent attenuation, which can make the determination process of the operating state of the circuit breaker very uncertain or even impossible.

In the market, it is quite felt the need for innovative solutions able to overcome or mitigate the above-mentioned technical issues of these recent solutions of the state of the art.

The present invention intends to respond to this need by providing a method for probing a circuit breaker, according to the following claim 1 and the related dependent claims.

In a further aspect, the present invention relates to a device for monitoring an operating state of a circuit breaker, according to the following claim 15.

In yet a further aspect, the present invention relates to a low-voltage electrical system, according to the following claim 16.

Characteristics and advantages of the present invention will emerge more clearly from the description of preferred, but not exclusive embodiments of the monitoring method, according to the invention, of which non-limiting examples are shown in the attached drawings, wherein:

- figure 1 is a schematic view showing an electrical system including a circuit breaker and a monitoring device operatively associated to said circuit breaker and capable of carrying out the probing method of the invention;
- figures 2-4 are schematic diagrams showing the operating steps of the probing method of the invention;
- figures 5-6 are schematic diagrams showing the operating steps of a monitoring method including the probing method of the invention;

With reference to the above-mentioned figures, the present invention concerns improved monitoring solutions for electrical systems (e.g. electric grids, electric switchgear systems, electric switchboards, and the like), which preferably operate at low-voltage levels, i.e. at voltage levels lower than 1,5 kV AC and 2,0 kV DC. More particularly, the present invention relates to an improved probing method 100 of a circuit breaker in an electrical system.

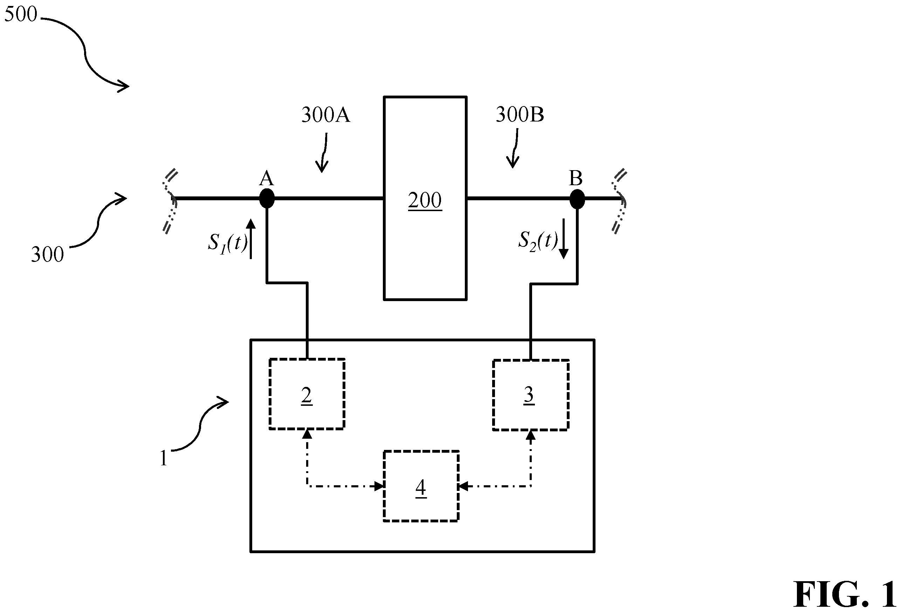

Figure 1 shows an exemplary electrical system 500 operating at low-voltage levels.

The electrical system 500 comprises a low-voltage electric line 300, which is intended to connect electrically two different grid sections, each of which may include one or more electric power sources and/or one or more electric loads.

The electric line 300 can comprise one or more phase conductors and, possibly, also a neutral conductor. As an example, the electric line 300 may be arranged according to a 1P+N configuration, a 3P configuration, a 3P+N configuration, or a 2P+N configuration.

The electrical system 500 comprises a circuit breaker 200 operatively coupled to the electric line 300. Namely, the circuit breaker 200 is electrically connected between a first line section 300A and a second line section 300B of the electric line 300.

In general, the circuit breaker 200 may be of any type adapted for the employment in an electrical system operating at AC or DC low-voltage levels. For example, it may be a MCB (Miniature Circuit Breaker), a RCCB (Residual Current Circuit Breaker) device, or a RCBO (Residual Current circuit Breaker with Overcurrent protection) device, or a RCM (Residual Current Monitor) device, or the like.

In operation, the circuit breaker 200 can take a closed state, at which it allows the flow of a current along the electric line 300, or can take an open or tripped state, at which it prevents a current to flow along the electric line 300.

A transition from a closed state to an open or tripped state forms an opening manoeuvre or a tripping manoeuvre of the circuit breaker 200 while a transition from an open or tripped state to a closed state forms a closing manoeuvre of the circuit breaker.

Depending on how the electrical system 500 is configured, the energy flow along the electric line 300 can be directed from the first line section 300A to the second line section 300B, or vice-versa. For the circuit breaker 200, each of the line sections 300A, 300B may thus be considered as an input power supply line or an output power supply line.

In general, the electric line 300 and the circuit breaker 200 of the electrical system 500 may be realized according to solutions of known type. In the following, these elements will thus not be described in more details for the sake of brevity.

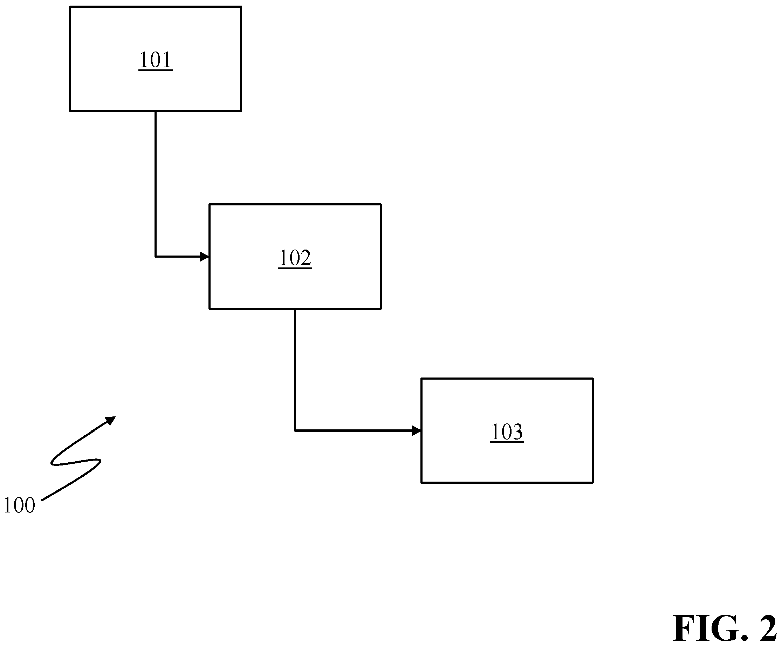

Referring now to figure 2, the probing method 100, according to the invention, is now described in detail.

According to the invention, the probing method 100 comprises a step 101, in which one or more first signals $S_1(t)$ are generated and injected at a first point A (injection point) of the electric line 300.

In the embodiment shown in figure 1, the first point A, at which the one or more first signals $S_1(t)$ are injected, is located at the first line section 300A of the electric line. In principle, however, it can be positioned anywhere along the electric line, for example at the second line section 300B of the electric line.

Preferably, the one or more first signals $S_1(t)$ are current or voltage signals having high frequency content, for example in the order of MHz.

Preferably, the one or more first signals $S_1(t)$ are AC signals.

The one or more first signals $S_1(t)$, which are injected into the electric line 300, have a frequency content at least partially included in a predefined frequency range F spanning, for example, between 1 MHz to 10 MHz. As an example, the one or more first signals $S_1(t)$ take at least some different frequency values included in the predefined frequency range F, or have an instantaneous frequency value varying continuously in the predefined frequency range F, or have a frequency spectrum spanning across the predefined frequency range F.

According to the invention, the probing method 100 comprises a second step 102, in which one or more second signals $S_2(t)$ are detected at a second point B (detection point) of the electric line 300.

In the embodiment shown in figure 1, the second point B, at which the one or more second signals $S_2(t)$ are detected, is located at the second line section 300B of the electric line. In principle, however, it can be positioned anywhere along the electric line, for example at the first line section 300A of the electric line.

Preferably, the one or more second signals $S_2(t)$ are AC signals.

Preferably, the one or more second signals $S_2(t)$ are current or voltage signals having high frequency content, for example in the order of MHz.

The one or more second signals $S_2(t)$ are detected with a detection frequency band DFB, which is conveniently calculated based on the frequency range F including the frequency content of the one or more first signals $S_1(t)$ injected at the first point A of the electric line.

According to the invention, the probing method 100 comprises a third step 103, in which a frequency response function *G(f)* of the electric line 300 is calculated.

The frequency response function *G(f)* is indicative of the frequency response of the electric line 300 to the injection of the one or more first signals *S₁(t)* injected at the first point A of said electric line. In practice, the frequency response function *G(f)* describes the behaviour (in frequency) of the communication channel between the points A, B of the electric line.

The frequency response function *G(f)* of the electric line 300 is calculated in the predefined frequency range *F* including the frequency content of the one or more first signals *S₁(t)* and it is reconstructed based on the one or more second signals *S₂(t)* detected at the second point B of the second line section 300B.

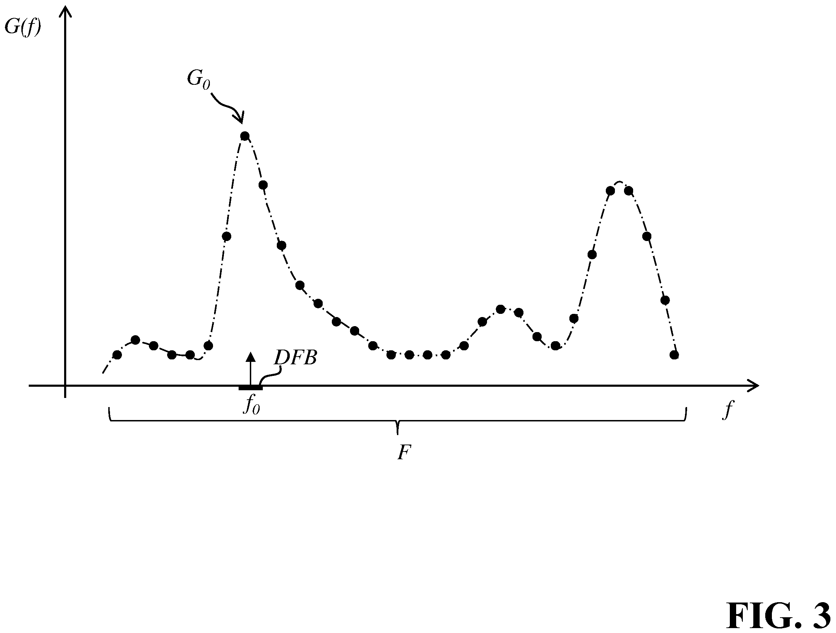

Figures 3-4 show examples of frequency response functions *G(f)* of the electric line as reconstructed according to the probing method 100 of the invention.

As it is possible to notice, the magnitude (e.g., measured in Volt) of the frequency response function *G(f)* shows large variations across frequency in the predefined frequency range *F* including the frequency content of the one or more first signals injected at the first point A of the electric line 300.

This behaviour is basically due to the circumstance that the signal attenuation, to which the injected one or more first signals *S₁(t)* are subject, varies remarkably with frequency depending on the nature and layout of the electric loads electrically connected to the electric line and the cabling characteristics and topology of the electric line.

Notwithstanding the above, the reconstructed frequency response function *G(f)* of the electric line provides information on the signal attenuation along this latter. For example, it allows identifying certain frequencies, at which the above-mentioned signal attenuation is relatively low. As it will be better explained in the following, this allows collecting detection data that can be suitably processed to determine the state of the circuit breaker 200 with an elevated level of reliability.

According to some embodiments of the invention, the first step 101 of the probing method 100 includes injecting a plurality of first sinusoidal signals *S₁(t)* at the first point A of the electric line 300.

The one or more first sinusoidal signals *S₁(t)* are distinct one from another and have each a predefined frequency included in the predefined frequency range *F*.

Preferably, each first sinusoidal signal *S₁(t)* is injected for a predefined injection time interval. Preferably, the first sinusoidal signals *S₁(t)* are injected in sequence one after the other until the predefined frequency range *F* is covered with a desired frequency resolution value.

According to these embodiments of the invention, the second step 102 of the probing method 100 includes detecting a plurality of second signals *S₂(t)* at the second coupling point *B* of the electric line 300.

Each second signal *S₂(t)* is detected in response to the injection of a corresponding first sinusoidal signal *S₁(t)* at the first point A of the electric line 300.

Preferably, each second signal *S₂(t)* is detected for a predefined detection time interval, which may correspond to the predefined injection time interval of the corresponding injected first sinusoidal signal *S₁(t)*.

In general, the one or more detected second signals *S₂(t)* are not sinusoidal signals as they include spurious components that need to be filtered.

For this reason, according to the invention, each second signal *S₂(t)* is detected with a detection frequency band DFB including the frequency value of a corresponding injected first sinusoidal signal *S₁(t)*. In this way, possible signal components at frequencies different from the frequency value taken by the injected first sinusoidal signal *S₁(t)* can be filtered (figure 3).

Preferably, the detection frequency band DFB is centred on the frequency value of a corresponding injected first sinusoidal signal *S₁(t)*.

The width of the detection frequency band DFB basically depends on the bandwidth of the injected first sinusoidal signals *S₁(t)*. In general (figure 3), the detection frequency band DFB for detecting a generic second signal *S₂(t)* is relatively narrow compared to the extension of the predefined frequency range *F*. For example, the detection frequency band DFB for detecting a second signal *S₂(t)* having a certain frequency *f₀* may be of *DFB=0.2* MHz, if the predefined frequency range *F* spans between 1 MHz and 10 MHz with a frequency resolution value of 0.25 MHz.

According to the above-mentioned embodiments of the invention, the third step 103 of the probing method 100 includes calculating, for each detected second signal *S₂(t)*, an average power value *P* over time of said second signal.

Preferably, the average power value *P* of each second signal *S₂(t)* is calculated over the above-mentioned detection time interval, during which said second signal is detected.

The calculation of the average power value *P* of each second signal *S₂(t)* can be conveniently carried out through well-known signal processing techniques.

As an example, the average power value *P₀* of a second signal *S₂(t)* detected in response to the injection of a first sinusoidal signal *S₁(t)* having a certain frequency *f₀* can be calculated according to the following relationship:

$$P_0 = \frac{1}{T}\int_0^T |S_{2B}(t)^2| dt$$

where *T* is the detection time interval of the detected second signal *S₂(t)* and *S₂B(t)* is the detected second signal *S₂(t)* filtered in a detection frequency band DFB including the frequency *f₀* of the injected first sinusoidal signal *S₁(t)*.

According to the above-mentioned embodiments of the invention, the third step 103 of the probing method 100 further includes calculating the frequency response function $G(f)$ of the electric line 300 based on the average power values $P_0$ calculated for the detected second signals $S_2(t)$.

The calculation of the frequency response function $G(f)$ can be also carried out through well-known signal processing techniques.

As shown in figure 3, the frequency response function $G(f)$ of the electric line 300 can be calculated as a succession of magnitude values $G$, each of which is calculated based on the average power values $P$ calculated for a corresponding detected second signal $S_2(t)$.

As an example, for a certain second signal $S_2(t)$ detected in response to the injection of a first sinusoidal signal $S_1(t)$ having a certain frequency $f_0$, a magnitude value $G_0$ of the frequency response function $G(f)$ may be calculated based on the following relationship:

$$G_0 = \sqrt{P_0}$$

where $P_0$ is the average power value calculated for the detected second signal $S_2(t)$ as illustrated above.

The frequency response function $G(f)$ of the electric line 300 can thus be reconstructed by calculating a succession of magnitude values corresponding to the different frequencies of the injected first sinusoidal signals $S_1(t)$.

According to further embodiments of the invention, the first step 101 of the probing method 100 includes injecting (at the first point A of the electric line) a first signal $S_1(t)$ having a frequency value continuously varying in time (with a given rate of change that may be constant or variable in time) within the predefined frequency range $F$.

As an example, the first signal $S_1(t)$ can be a frequency modulated signal (e.g., a chirp-up signal) having an instantaneous frequency increasing (e.g., linearly) in time and having frequency values within the predefined frequency range $F$.

According to these further embodiments of the invention, the second step 102 of the probing method 100 includes detecting (at the second point B of the electric line) a second signal $S_2(t)$ with a detection frequency band varying in time so as to include the instantaneous frequency value taken by a corresponding injected first signal $S_1(t)$. In this way, signal components at frequencies different from the instantaneous frequency value taken by a corresponding injected first signal $S_1(t)$ can be filtered.

Preferably, the detection frequency band is centred on the instantaneous frequency value taken by a corresponding injected first signal $S_1(t)$.

Advantageously, the detection frequency band of the second signal $S_2(t)$ varies in time according to the rate of change of the frequency of the injected first signal $S_1(t)$. The instantaneous power value $P(\tau)$ of the second signal $S_2(t)$ detected in response to the injection of the first signal $S_1(t)$ can be calculated over a moving time window $[\tau - \Delta\tau, \tau + \Delta\tau]$ according to the following relationship:

$$P(\tau) = \frac{1}{2\Delta\tau} \int_{\tau-\Delta\tau}^{\tau+\Delta\tau} |S_2(t)^2| \, dt.$$

According to these embodiments of the invention, the frequency response function $G(f)$ of the electric line 300 can be directly calculated based on the calculated power $P(\tau)$. In fact, this latter is indicative of the magnitude of the frequency response function $G(f)$ as it is the result of a time-to-frequency mapping applied to $P(\tau)$, enabled by the corresponding injected first signal $S_1(t)$ having a known frequency continuously variable in time.

The calculation of the frequency response function $G(f)$ can be carried out through well-known signal processing techniques.

As an example, the frequency response function $G(f)$ of the electric line 300 can be calculated according to the following relationship:

$$G(f) = P(k(f))$$

where $P(\tau)$ is the computed instantaneous power of the detected second signal $S_2(t)$ and $k(f)$ is a function defining the frequency variation of the injected first signal $S_1(t)$ with time. The function $k(f)$ thus maps the time axis into frequency to reconstruct the frequency response function. The mapping function $k(f)$ is linear in case the frequency value of the injected first signal $S_1(t)$ varies linearly as explained above by way of example.

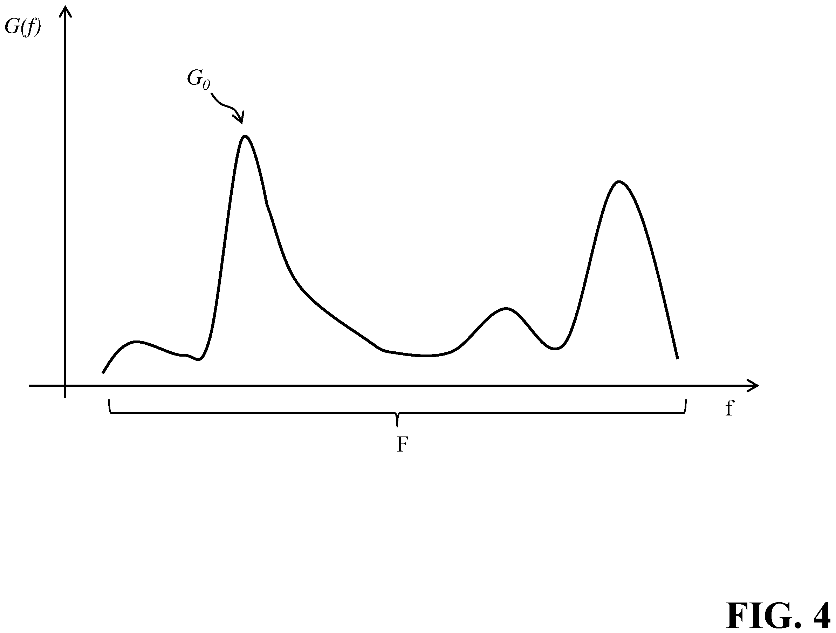

Figure 4 shows an example of frequency response function $G(f)$ of the electric line 300 calculated according to these further embodiments of the invention. As it is possible to notice, the frequency response function $G(f)$ can be a continuous function having a frequency domain corresponding to the predefined frequency range $F$.

According to further embodiments of the invention, the first step 101 of the probing method 100 includes injecting (at the first point A of the electric line) a first signal $S_1(t)$ having a frequency spectrum, which extends across the predefined frequency range $F$.

As an example, the first signal $S_1(t)$ can be shaped as a normalized $sinc(t)$ function and expressed as: $S_1(t) = \dfrac{\sin \pi t}{\pi t}$ in such a way to have a frequency spectrum substantially shaped as a $rect(f)$ function, which has a frequency domain covering the predefined frequency range $F$. According to these further embodiments of the invention, the second step 102 of the probing method 100 includes detecting (at the second point B of the electric line) a second signal $S_2(t)$ with a detection frequency band having a width corresponding to the predefined frequency range $F$ in such a way to filter signal components at frequencies not included in the predefined frequency range $F$.

According to these further embodiments of the invention, the frequency response function $G(f)$ of the electric line 300 is calculated by calculating the frequency spectrum of the detected second signal $S_2(t)$.

The frequency spectrum of the detected second signal $S_2(t)$ can be calculated through well-known signal processing techniques, for example FFT processing techniques.

The frequency spectrum of the detected second signal $S_2(t)$ directly represents the frequency response function $G(f)$ of the electric line to the injection of the first signal $S_1(t)$.

Referring again to figure 4, the frequency response function $G(f)$ of the electric line 300 calculated according to these embodiments of the invention can also be a continuous function having a frequency domain corresponding to the predefined frequency range $F$.

The probing method 100 of the invention can be advantageously employed in methods for monitoring the state of the circuit breaker 200 to collect information indicative of the operating state of this latter.

The calculation of the frequency response function $G(f)$ of the electric line 300 in response to the injection of the one or more first signals $S_1(t)$ allows identifying specific frequencies or frequency bands of the predefined frequency range $F$, at which the calculated frequency response functions $G(f)$ indicate that a relatively low signal attenuation is introduced.

As a consequence, the behaviour of the circuit breaker 200 can be monitored in a robust and reliable manner, substantially independent from the physical layout and characteristics of the electric loads electrically connected to the electric line 300 and from the cabling characteristics and topology of the electric line.

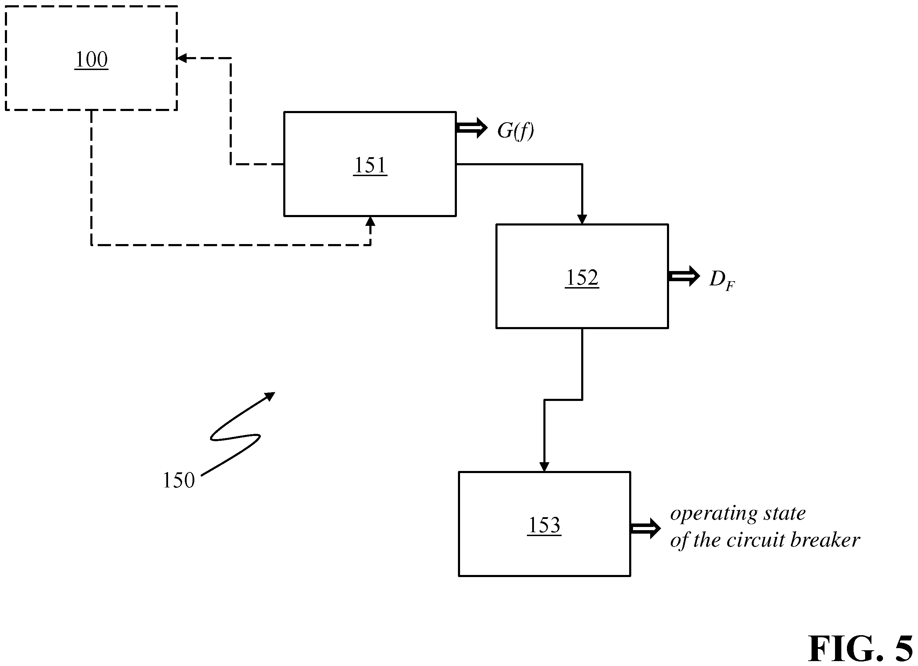

Figure 5 shows an exemplary preferred embodiment of a method 150 for monitoring the operating state of a circuit breaker 200.

Preferably, the monitoring method 150 comprises a step 151 of repeating cyclically the probing method 100 of the invention to calculate the frequency response function $G(f)$ of the electric line 300 at subsequent iteration cycles of the probing method.

Preferably, the monitoring method 150 comprises a step 152 of processing the calculated frequency response functions $G(f)$ to obtain detection data $D_F$ indicative of a behaviour of the circuit breaker 200 at subsequent iteration cycles of the probing method.

Preferably, the detection data $D_F$ comprises a collection of magnitude values at subsequent time instants, each of which represents the time instant in which a repetition cycle of the probing method is completed, and a corresponding frequency response functions $G(f)$ is calculated.

These magnitude values can be conveniently selected for specific frequencies or frequency bands of the predefined frequency range $F$, at which the calculated frequency response functions $G(f)$ show that a relatively low signal attenuation is introduced.

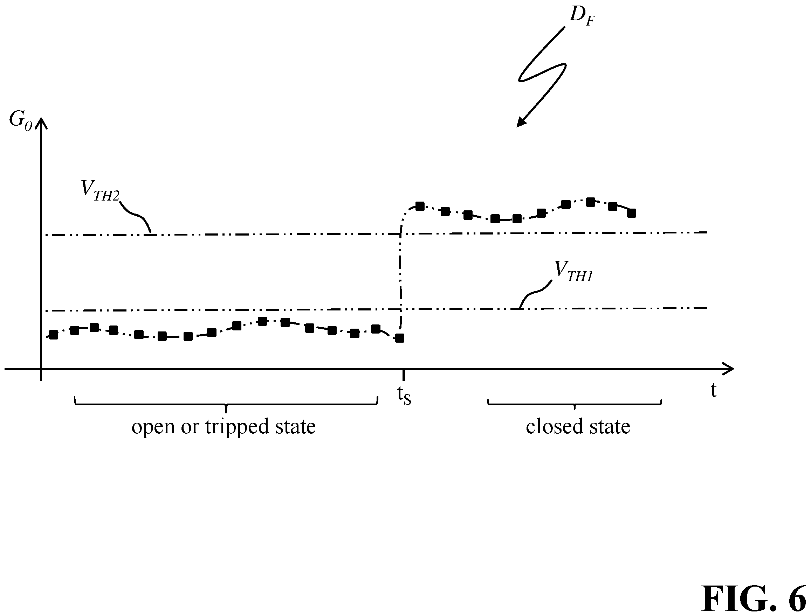

As an example, referring to figure 6, the detection data $D_F$ may comprise a collection of magnitude values $G_0$, each of which is selected at a frequency at which the corresponding calculated frequency response function $G(f)$ takes a maximum value.

As a further example, the detection data $D_F$ may comprise a collection of magnitude values, each of which is computed as the average value of the frequency response function $G(f)$ over a suitable frequency range.

The detection data $D_F$ are indicative of the behaviour of the circuit breaker 200 as the frequency response function $G(f)$ of the electric line 300 at a given instant in time is strongly influenced by the operating state of the circuit breaker at said time instant.

As they are selected for frequencies at which the possible influence of electric loads electrically connected to the electric line and of the cabling characteristics and topology is reduced, the detection data $D_F$ can represent in a robust manner the behaviour of the circuit breaker 200 at subsequent instants in time.

The monitoring method 150 thus comprises a step 153 of processing the detection data $D_F$ to determine an operating state of a circuit breaker.

According to possible variants of the monitoring method, the detection data $D_F$ are compared with one or more threshold values $N_{TH1}$, $V_{TH2}$ to determine the operating state of the circuit breaker 200. Based on the result of such a comparison, the operating state of the circuit breaker is determined.

Figure 6 shows an exemplary representation of detection data $D_F$ obtained during the execution of a closing manoeuvre by the circuit breaker 200 (switching instant ts).

As it is possible to notice, the collected magnitude values $G_0$ are relatively low before the switching instant ts (circuit breaker in an open or tripped state) and are relatively high after the switching instant ts (circuit breaker in a closed state).

By comparing the collected magnitude values $G_0$ with a lower threshold value $V_{TH1}$ and with a higher threshold value $V_{TH2}$, it is possible to determine the operating state of the circuit breaker or understand whether the circuit breaker is carrying out a state transition.

According to other possible variants of the monitoring method, the detection data $D_F$ are classified through a suitable classification method. To this aim, classification methods of known type can be adopted, for example classification methods employing support vector machine or k-nearest neighbour classifiers trained on reference data acquired in controlled conditions with known operating states of the circuit breakers.

Based on the result of such a classification, the operating state of the circuit breaker 200 is determined.

In a further aspect, the present invention relates to a device 1 for monitoring an operating state of a circuit breaker.

Referring back to figure 1, the monitoring device 1 preferably comprises a signal transceiver module 2, 3 and a signal processor module 4.

The signal transceiver module comprises a transmitter arrangement 2, which is operatively coupled (e.g., in a capacitive or inductive manner) to the electric line 300 at the first point A, and a receiver arrangement 3, which is operatively coupled (e.g. in a capacitive or inductive manner) to the electric line 300, at the second point B.

As mentioned above, the injection and detection points A, B may be located at a same line section 300A or 300B or be located at different line sections 300A, 300B as in the exemplary embodiment shown in figure 1.

The signal processor module 4 is operatively coupled with the signal transmitter arrangement 2 and the receiver arrangement 3 in such a way to exchange data signals and command signals with the latter.

In many aspects, the monitoring device 1 can be realized industrially according to solutions of known type, for example according to the solutions described in the above-mentioned patent document EP4119959A1.

However, the monitoring device 1 is equipped with signal processing means (which may be of digital and/or analog type) configured to carry out the probing method 100 of the invention described above.

In some embodiments, the monitoring device 1 is equipped with signal processing means (which may be of digital and/or analog type) configured to carry out the monitoring method 150 described above.

In an electrical system 500, the monitoring device 1 can be mounted onboard or integrated in the circuit breaker 200 or constitute a separate unit from this latter. In this case, the monitoring device 1 does not need to be mounted in the immediate vicinity of the circuit breaker but it can be advantageously mounted in a suitable position within an electrical switchboard or panel.

It has been seen in practice how the monitoring solutions provided by the present invention provide relevant technical advantages over the state of the art.

The probing method, according to the invention, allows collecting a comprehensive information about the frequency behaviour of the communication channel between the signal injection point A and signal detection point B of the electric line.

This allows monitoring the operating state of a circuit breaker in a robust and reliable manner, substantially independent from the physical layout and nature of the electric loads electrically connected to the electric line and from the cabling characteristics and topology of the electric line.

The solution proposed by the claimed invention therefore allows a more efficient and safer determination of the operating state of a circuit breaker, thereby reducing the risk that faults or malfunctions of the electrical system remain unattended and favouring the execution of urgent interventions in case of faults.

The probing method, according to the invention, requires relatively small computational resources to be carried out and is relatively easy and cheap to implement at industrial level. Also, the described monitoring method and the monitoring device, according to the invention, are relatively easy to implement at industrial level at competitive costs with currently available solutions of the state of the art.

**Claims**

1. Method (100) for probing a circuit breaker (200), wherein said circuit breaker is electrically connected to an electric line (300), **characterised in that** said method comprises the following steps:

   - injecting (101) one or more first signals ($S_1(t)$) at a first point (A) of said electric line (300), wherein said one or more first signals have frequency content at least partially included in a predefined frequency range (F);
   - detecting (102) one or more second signals ($S_2(t)$) at a second point (B) of said electric line (300), wherein said one or more second signals are detected with a detection frequency band calculated based on said frequency range (F);
   - calculating (103) a frequency response function (G(f)) indicative of a frequency response of said electric line (300) in said frequency range (F) based on the detected one or more second signals ($S_2(t)$).

2. Method, according to claim 1, **characterised in that** injecting (101) said one or more first signals comprises:

   - injecting a plurality of first sinusoidal signals ($S_1(t)$), each first sinusoidal signal having a predefined frequency value included in said predefined frequency range (F).

3. Method, according to claim 2, **characterised in that** detecting (102) said one or more second signals comprises:

   - detecting a plurality of second signals ($S_2(t)$), each second signal being detected with a detection frequency band (DFB) including the frequency value of a corresponding injected first sinusoidal signal ($S_1(t)$).

4. Method, according to claim 3, **characterised in that** calculating (103) the frequency response function (G(f)) of said electric line (300) comprises:

- calculating, for each detected second signal $(S_2(t))$, an average power value $(P)$ over time of said second signal;
- calculating said frequency response function $(G(f))$ based on the average power values $(P)$ calculated for the detected second signals $(S_2(t))$.

5.  Method, according to claim 1, **characterised in that** injecting (101) said one or more first signals comprises:

- injecting a first signal $(S_1(t))$ having an instantaneous frequency value continuously varying in time within said predefined frequency range $(F)$.

6.  Method, according to claim 5, **characterised in that** detecting (102) said one or more second signals comprises:

- detecting a second signal $(S_2(t))$ with a detection frequency band varying in time so as to include the instantaneous frequency value taken by a corresponding injected first signal $(S_1(t))$.

7.  Method, according to claim 6, **characterised in that** the frequency response function $(G(f))$ of said electric line (300) is calculated based on the instantaneous power $(P(\tau))$ of the detected second signal $(S_2(t))$.

8.  Method, according to claim 1, **characterised in that** injecting (101) said one or more first signals comprises:

- injecting a first signal $(S_1(t))$ having a frequency spectrum extending across said predefined frequency range $(F)$.

9.  Method, according to claim 8, **characterised in that** detecting (102) said one or more second signals comprises:

- detecting a second signal $(S_2(t))$ with a detection frequency band having a width corresponding to said predefined frequency range $(F)$.

10. Method, according to claim 9, **characterised in that** the frequency response function $(G(f))$ of said electric line (300) is calculated by calculating the frequency spectrum of the detected second signal $(S_2(t))$.

11. Method (150) for monitoring an operating state of a circuit breaker (200), wherein said circuit breaker is electrically connected to an electric line (300), **characterised in that** said method comprises the following steps:

- repeating (151) cyclically a probing method (100), according to one of the previous claims, to calculate the frequency response function $(G(f))$ of said electric line (300) at subsequent iteration cycles of said probing method;
- obtaining (152) detection data $(D_F)$ indicative of a behaviour of said circuit breaker (200) at subsequent iteration cycles of said probing method;
- processing (153) said detection data $(D_F)$ to determine an operating state of said circuit breaker (200).

12. Method, according to claim 11, **characterized in that** processing (153) said detection data $(D_F)$ comprises:

- comparing said detection data $(D_F)$ with one or more of predefined threshold values $(V_{TH1}, V_{TH2})$;
- determining the operating state of said circuit breaker (200) based on a result of said comparison.

13. Method, according to claim 11 or 12, **characterized in that** processing (153) said detection data $(D_F)$ comprises:

- classifying said detection data $(D_F)$ through a classification method;
- determining the operating state of said circuit breaker (200) based on a result of said classification.

14. A device (1) for monitoring an operating state of a circuit breaker (200) **characterised in that** it is configured to carry out a method (100), according to one of the claims from 1 to 10.

15. A device, according to claim 14, **characterised in that** it is configured to carry out a method (150), according to one of the claims from 11 to 13.

16. A low-voltage electrical system (500) comprising:

- an electric line (300);
- a circuit breaker (200) electrically connected to said electric line (300);
- a device (1), according to claim 14 or 15, for monitoring an operating state of said circuit breaker.

FIG. 1

EP 4 760 284 A1

**FIG. 2**

$G(f)$

$G_0$

$DFB$

$f_0$

$F$

$f$

**FIG. 3**

$G(f)$

$G_0$

$F$

$f$

**FIG. 4**

EP 4 760 284 A1

$G(f)$

$D_F$

operating state
of the circuit breaker

**FIG. 5**

FIG. 6

EP 4 760 284 A1

EP 4 760 284 A1

# EUROPEAN SEARCH REPORT

**Application Number**

EP 24 22 0091

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2006/212745 A1 (ZANSKY ZOLTAN [US] ET AL) 21 September 2006 (2006-09-21) * the whole document * ----- | 1-16 | INV. G01R31/28 G01R31/327 |
| X | US 2020/309846 A1 (BARTHEL SVEN [DE]) 1 October 2020 (2020-10-01) * the whole document * ----- | 1-16 | ADD. G01R31/11 |
| A,D | EP 4 119 959 A1 (ABB SCHWEIZ AG [CH]) 18 January 2023 (2023-01-18) * claim 1 * ----- | 1-16 | |

**TECHNICAL FIELDS SEARCHED (IPC)**

G01R

The present search report has been drawn up for all claims

| Place of search | Date of completion of the search | Examiner |
|---|---|---|
| Munich | 30 May 2025 | Dogueri, Ali Kerem |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 22 0091

This annex lists the patent family members relating to the patent documents cited in the above-mentioned European search report.
The members are as contained in the European Patent Office EDP file on
The European Patent Office is in no way liable for these particulars which are merely given for the purpose of information.

30-05-2025

| Patent document cited in search report | Publication date | Patent family member(s) | | Publication date |
|---|---|---|---|---|
| US 2006212745 A1 | 21-09-2006 | NONE | | |
| US 2020309846 A1 | 01-10-2020 | NONE | | |
| EP 4119959 A1 | 18-01-2023 | CN | 115701004 A | 07-02-2023 |
| | | EP | 4119959 A1 | 18-01-2023 |
| | | US | 2023019486 A1 | 19-01-2023 |

EPO FORM P0459

For more details about this annex : see Official Journal of the European Patent Office, No. 12/82

**REFERENCES CITED IN THE DESCRIPTION**

**Patent documents cited in the description**

- EP 4119959 A1